# FASCICULE DE BREVET EUROPEEN

(11) **EP 0 434 803 B1**
(45) Date de publication et mention de la délivrance du brevet: **09.02.1994**
(21) Numéro de dépôt: 90910136.2
(22) Date de dépôt: 20.06.1990
(51) Int. Cl.: G01F 15/06, G01R 11/02

(54) **SUPPORT DE CAPTEUR OPTO-ELECTRONIQUE POUR COMPTEUR DE CONSOMMATION D'ENERGIE**
TRAEGER EINES LICHTELEKTRISCHEN SENSORS FÜR ENERGIEMESSER
SUPPORT OF OPTO-ELECTRONIC PICK-UP FOR ENERGY CONSUMPTION COUNTER

(30) Priorité: 21.06.1989 FR 8908268
(43) Date de publication de la demande: 03.07.1991
(73) Titulaire: MANUFACTURE D'APPAREILLAGE ELECTRIQUE DE CAHORS, F-46003 Cahors Cédex (FR)
(72) Inventeur: PISTOULEY, Christophe, F-66430 Bompas (FR)
(74) Mandataire: Keib, Gérard
(86) Numéro de dépôt international: FR9000447
(87) Numéro de publication internationale: WO9015971

(56) Documents cités:
- EP-A- 0 003 153
- FR-A- 2 614 098
- GB-A- 2 034 882
- US-A- 4 803 484

## Description

La présente invention concerne un support de capteur optoélectronique pour compteurs de consommation d'énergie domestique tels que compteurs d'électricité.

Actuellement, les compteurs d'électricité affichent sur leur face avant une série de chiffres qui expriment la consommation d'électricité. Ces chiffres sont relevés périodiquement pour établir la facture de consommation. Ces relevés périodiques sont très contraignants et onéreux.

De nombreuses solutions ont été proposées pour supprimer les relevés précités. Ces solutions décrites dans les brevets GB 2 034 882, US 4 803 484 et FR 2 614 098 ont consisté à placer à l'intérieur du compteur un capteur capable de détecter le passage d'un repère sur un disque rotatif à chaque tour de celui-ci.

Comme décrit dans la demande de brevet EP 0003153, à chaque détection du repère, un composant électronique associé au capteur délivre un signal électrique. Ces signaux électriques peuvent être convertis en consommation d'électricité.

Le relevé de la consommation peut ainsi être effectué à distance.

La fixation de ces capturs à l'intérieur des compteurs d'électricité pose toutefois des difficultés.

Il s'agit en effet de placer ces capteurs à une distance constante et précise du disque rotatif portant le repère, de façon à obtenir des mesures fiables et reproductibles.

On connaît par le brevet US 4 792 677 un compteur de consommation d'électricité dans lequel on peut monter un capteur en logeant celui-ci dans un support qui est vissé avec la plaque signalétique. Le montage d'un tel capteur nécessite donc de dévisser la plaque signalétique, puis de revisser celle-ci avec le support.

Les solutions proposées jusqu'à présent ne sont pas satisfaisantes, car elles impliquent des temps de montage excessifs. D'autres solutions impliquent également des modifications aux compteurs.

Le but de la présente invention est de remédier aux inconvénients des solutions ci-dessus.

L'invention vise ainsi un support de capteur optoélectronique pour compteur de consommation d'électricité comprenant sur la face avant de son couvercle une plaque signalétique présentant une fenêtre derrière laquelle est montée en rotation un organe rotatif dont la vitesse de rotation est fonction de la consommation, le capteur étant destiné à être placé en regard de l'organe rotatif pour détecter le passage d'un repère porté par l'organe rotatif, à chaque tour de celui-ci.

Suivant l'invention, le support du capteur comprend une face pourvue d'une languette élastique apte à recouvrir le bord de la plaque signalétique, cette même face du support présentant un ergot pouvant se loger à l'extrémité de la fenêtre de la plaque signalétique adjacente au bord de celle-ci recouvert par la languette du support.

Ainsi le montage du capteur est très aisé et peut être effectué en très peu de temps, puisqu'il ne nécessite aucune modification du compteur.

Le support dans lequel est logé le capteur facilite la manipulation de celui-ci, tout en le protégeant.

De plus, ce support avec ses moyens de fixation rapide garantit une grande précision de montage à l'intérieur du compteur.

Etant donné que l'ergot est engagé dans la fenêtre de la plaque signalétique, le support du capteur est calé dans les deux sens de la longueur de la fenêtre d'une part par l'ergot en butée contre l'extrémité de cette fenêtre et d'autre part par le fond de la gorge définie par la languette qui est en butée contre le bord de la plaque.

De plus, l'ergot cale le support dans les deux directions de la largeur de la fenêtre. Ainsi, la fixation du support par rapport à la fenêtre de la plaque signalétique, permet de définir avec précision la distance entre le capteur et le disque rotatif portant le repère.

D'autres particularités et avantages de l'invention apparaîtront encore dans la description ci-après.

Aux dessins annexés :
- la figure 1 est une vue en élévation d'une face d'une première version d'un support de capteur pour compteur de consommation électrique,
- la figure 2 est une vue de la face opposée du support,
- la figure 3 est une vue en perspective schématique d'un compteur électrique dont le couvercle a été enlevé,
- la figure 4 est une vue en élévation de face, montrant le support du capteur en position sur le bord de la plaque signalétique et en regard du disque rotatif,
- la figure 5 est une vue en perspective avec arrachements, montrant la fixation du support à la plaque signalétique,
- la figure 6 est une vue en perspective du compteur muni de son couvercle,
- la figure 7 est une vue en élévation d'un support de capteur destiné à être fixé dans un compteur de consommation de gaz,
- la figure 8 est une vue en plan partielle d'un compteur à gaz démuni de son couvercle et dans lequel est fixé le support de capteur.

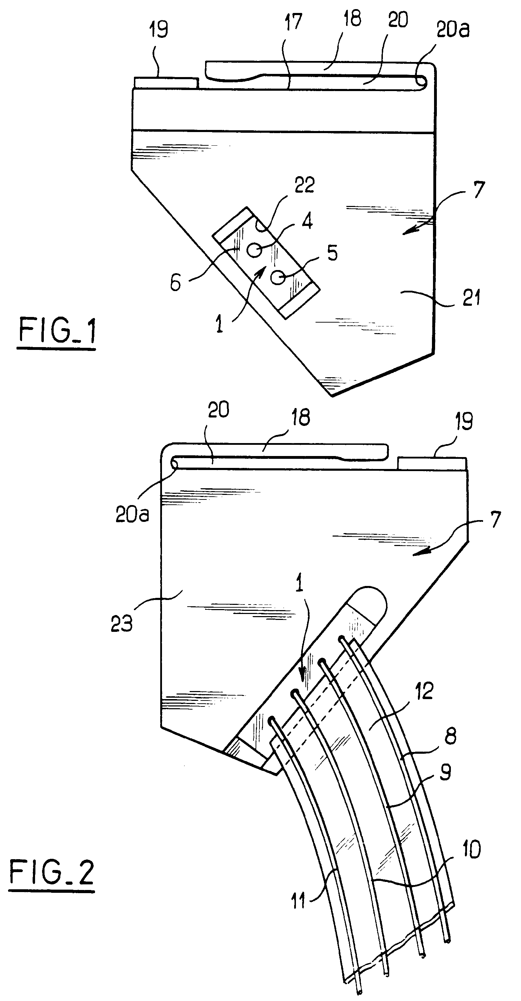

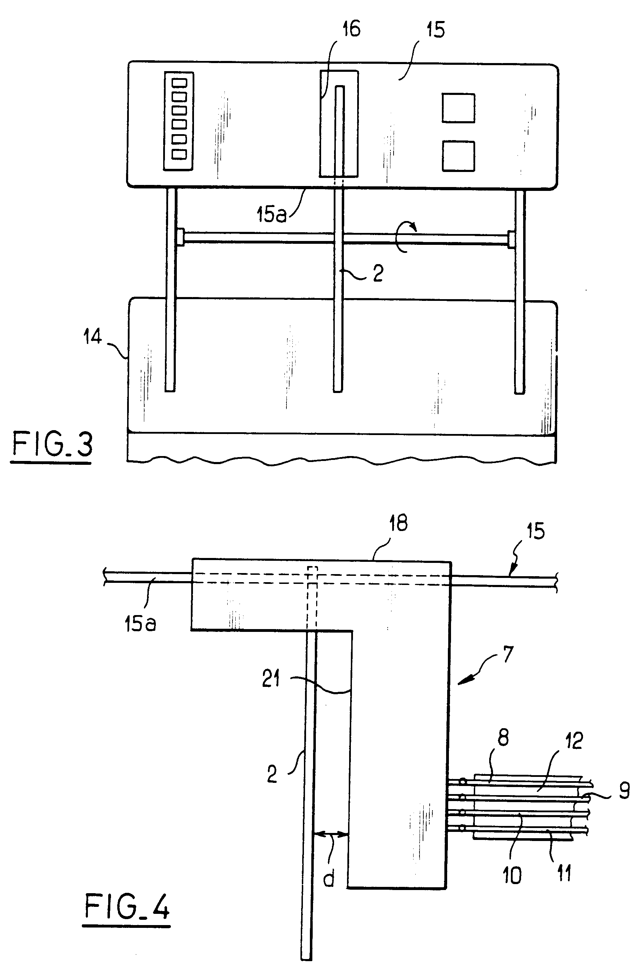

Dans la réalisation des figures 1 et 2, on a représenté un capteur optoélectronique 1 destiné à être fixé dans un compteur de consommation d'électricité qui comprend (voir figures 3 à 5) un disque rotatif 2 dont la vitesse de rotation est fonction de la consommation, le capteur 1 devant détecter le passage d'un repère 3 du disque rotatif 2, à chaque tour de celui-ci.

Le capteur 1 proprement dit comprend côte à côte une diode émettrice de rayonnement infra-rouge 4 par exemple en arséniure de gallium et un phototransistor 5 par exemple en silicium du type n-p-n, cette diode 4 et ce phototransistor 5 étant montés dans un corps en matière plastique 6.

La diode 4 émet un rayonnement qui est réfléchi sur une surface réfléchissante vers le phototransistor 5 qui convertit le rayonnement reçu en un signal électrique. Pour que la réflexion du rayonnement émis par la diode 4 puisse se faire avec précision vers le phototransistor 5, il faut que la surface réfléchissante soit située à une distance bien précise du capteur 1.

Dans le cas d'un compteur de consommation d'électricité, la surface réfléchissante est constituée par le disque rotatif 2 qui tourne à une vitesse proportionnelle à la puissance électrique consommée.

Ce disque 2 porte d'origine un repère noir 3 qui est ainsi détecté à chaque tour par le capteur 1.

Conformément à l'invention, le capteur 1 est logé dans un support 7 par exemple en matière plastique, comprenant des moyens permettant sa fixation par pincement élastique à une partie existant à l'intérieur du compteur, lesdits moyens maintenant le capteur 1 à une distance fixe d (voir figure 4) du disque rotatif 2 du compteur.

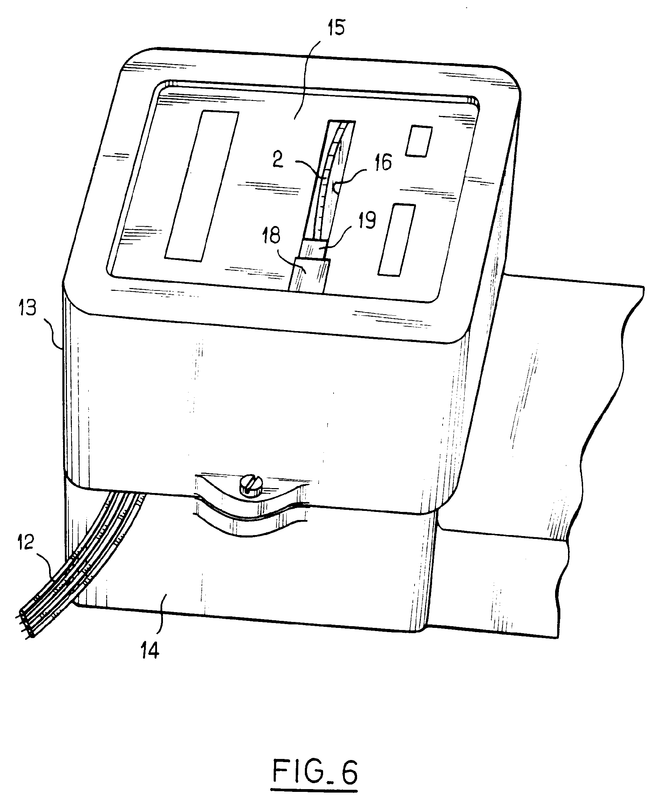

On voit sur les figures 2, 4, 5 et 6 que les conducteurs 8, 9, 10, 11 issus du capteur 1 sont noyés dans une bande souple 12 en matière plastique isolante suffisamment mince pour pouvoir passer (voir figure 6) entre le couvercle 13 du compteur et le corps 14 de celui-ci sans modification de ceux-ci.

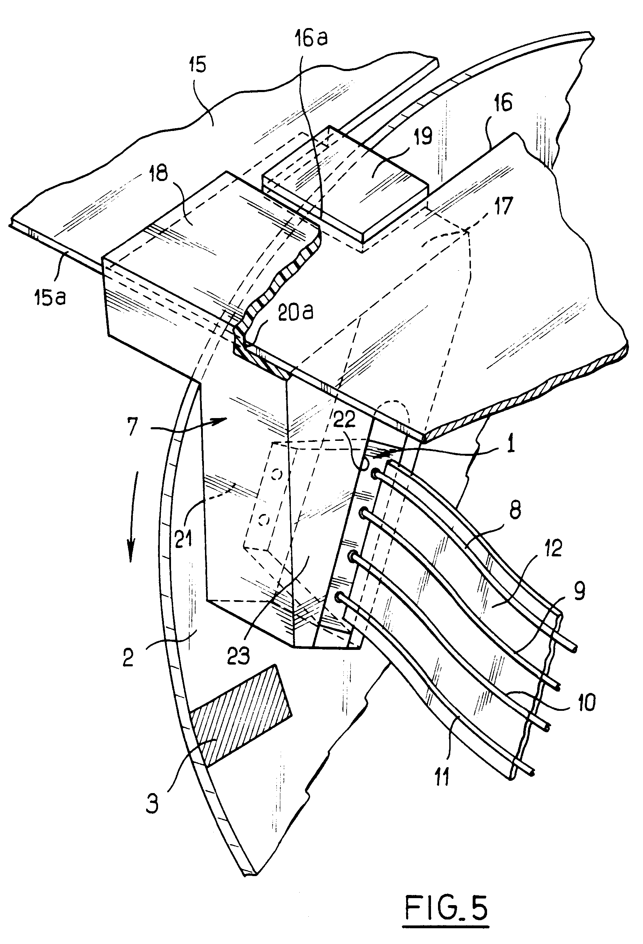

Le compteur de consommation d'électricité comprend sur la face avant de son couvercle 13 une plaque signalétique 15 présentant une fenêtre 16 rectangulaire derrière laquelle (voir figures 3 et 5) est montée en rotation le disque 2 portant le repère noir 3.

Le support 7 du capteur 1, comprend une face 17 pourvue d'une languette élastique 18 s'étendant parallèlement à cette face 17 et qui est apte à recouvrir le bord 15a de la plaque signalétique 15 comme indiqué sur la figure 5. Cette même face 18 du support 7 présente un ergot 19 pouvant se loger à l'extrémité 16a de la fenêtre 16 de la plaque signalétique 15 adjacente au bord 15a de celle-ci recouvert par la languette 18 du support 7.

Les dimensions de l'ergot 19 correspondent à celle de ladite extrémité 16a de la fenêtre 16 de façon à pouvoir s'emboîter sensiblement sans jeu dans celle-ci.

On voit également sur la figure 5, que le fond 20a de la gorge 20 définie entre la languette 18 et la face 17 du support 7 est situé à une distance de l'ergot 19 sensiblement égale à la distance comprise entre le bord 15a de la plaque et l'extrémité 16a de la fenêtre de celle-ci. Ainsi, l'ergot 19 est calé contre le bord 16a de la fenêtre et le fond 20a de la gorge 20 est calé contre le bord 15a de la plaque.

Par ailleurs, comme représenté sur les figures 1, 4 et 5, le support 7 présente une face 21 perpendiculaire à celle comportant la languette 18 et l'ergot 19. Cette face 21 comporte une ouverture 22 communiquant avec le logement du capteur 1. La distance entre l'ergot 19 et la face 21 est déterminée pour maintenir le capteur 1 logé derrière l'ouverture 22 à une distance d constante et appropriée du disque 2 monté en rotation dans un plan parallèle à ladite face 21. Cette distance d déterminée avec précision permet au rayonnement émis par la diode 4 de réfléchir sur le disque 2 et d'être reçu après réflexion par le phototransistor 5.

Par ailleurs, le support 7 présente une face 23 opposée à ladite face 21 présentant l'ouverture 22, de laquelle sortent les conducteurs 8, 9, 10, 11 connectés au capteur 1.

Le montage du support 7 dans le compteur de consommation d'électricité est extrêmement simple.

Il suffit d'enlever le couvercle 13 et d'engager la gorge 20 définie par la languette 18 sur le bord 15a de la plaque en regard de la fenêtre 16, puis de pousser le support 7 vers cette fenêtre jusqu'à ce que l'ergot 19 s'engage dans l'extrémité de la fenêtre.

On passe ensuite le ruban 12 comportant les conducteurs 8, 9, 10, 11 connectés au capteur 1, au-dessus du bord du corps 14 du compteur, puis on fixe le couvercle 13.

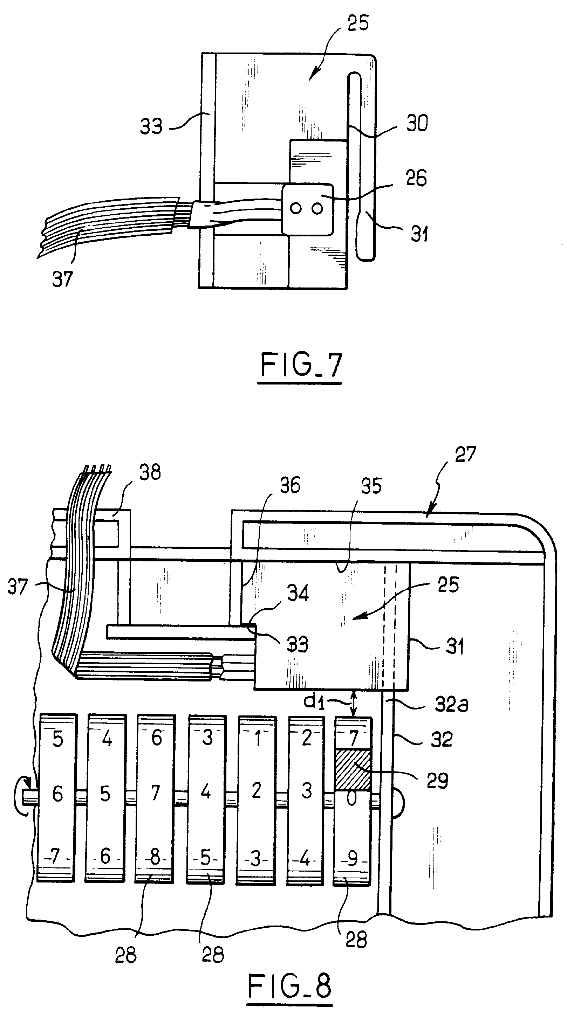

La figure 7 représente un support 25 de capteur 26 destiné à être placé dans un compteur de consommation de gaz. Le corps 27 de ce compteur (voir figure 8) comprend une série de roues graduées 28 entraînées en rotation. La vitesse de rotation de ces roues 28 est proportionnelle à la consommation. La dernière roue 28 porte un repère 29, par exemple constitué par une bande adhésive noire, destiné à être détecté par le capteur 26.

Le support 25 du capteur 26 comprend une face 30 pourvue d'une languette élastique 31 apte à recouvrir et pincer le bord 32a d'une paroi 32 s'étendant à l'intérieur du corps 27. Une autre face du support 25 présente un épaulement 33 destiné à prendre appui contre une surface 34 du corps 27 du compteur (voir figure 7) pour maintenir le capteur 26 porté par le support 25 à une certaine distance d₁ constante de la roue 28 portant un repère 29.

Dans l'exemple représenté sur la figure 8, le corps 27 du compteur comporte, en regard de la roue 28 portant un repère 29, un logement de section sensiblement en U ouvert vers ladite roue et délimité par trois parois 32, 35, 36 du corps. On voit sur cette figure 8 que le support 25 du capteur a une section adaptée aux dimensions dudit logement pour pouvoir s'emboîter dans ce dernier.

Comme dans la réalisation selon les figures 1 à 6, le montage du support 25 dans le corps 27 du compteur à gaz est très facile et ne nécessite aucune modification dudit compteur. De même, le ruban 37 portant les conducteurs reliés au capteur 26 peut être passé entre le bord 38 du corps 27 du compteur et le couvercle (non représenté) de celui-ci.

Bien entendu, l'invention n'est pas limitée aux exemples de réalisation que l'on vient de décrire et on peut apporter à ceux-ci de nombreuses modifications sans sortir du cadre de l'invention.

## Revendications

1. Support de capteur optoélectronique pour compteur de consommation d'électricité, ledit compteur comprenant sur la face avant de son couvercle (13) une plaque signalétique (15) présentant une fenêtre (16) derrière laquelle est montée en rotation un organe rotatif (2) dont la vitesse de rotation est fonction de la consommation, et le capteur optoélectronique (1) étant destiné à être placé en regard de l'organe rotatif (2) pour détecter le passage d'un repère (3), porté par ledit organe rotatif, à chaque tour de celui-ci, caractérisé en ce que ledit support (7) du capteur (1) comprend une face (17) pourvue d'une languette élastique (28) apte à recouvrir le bord (15a) de la plaque signalétique (15), cette même face (17) du support (7) présentant un ergot (19) pouvant se loger à l'extrémité de la fenêtre (16) de la plaque signalétique adjacente au bord (15a) de celle-ci recouvert par la languette (18) du support (7).

2. Support de capteur conforme à la revendication 1, caractérisé en ce que les dimensions de l'ergot (19), sont déterminées pour emboîter l'ergot sensiblement sans jeu dans ladite extrémité de la fenêtre (16).

3. Support de capteur conforme à l'une des revendications 1 ou 2, caractérisé en ce que le fond (20a) de la gorge (20) définie entre la languette (18) et ladite face (17) du support (7) est situé à une distance de l'ergot (19) sensiblement égale à la distance comprise entre le bord (15a) de la plaque et l'extrémité de la fenêtre (16) de celle-ci.

4. Support de capteur conforme à l'une des revendications 1 à 3, caractérisé en ce qu'il présente une face (21) perpendiculaire à celle comportant la languette (18) et l'ergot (19), cette face (21) comportant une ouverture (22) communiquant avec le logement du capteur (1), la distance entre l'ergot (19) et ladite face (21) étant déterminée pour maintenir le capteur (1) logé derrière l'ouverture (22) à une distance constante et appropriée de l'organe rotatif (2) monté en rotation dans un plan parallèle à ladite face.

5. Support de capteur conforme à la revendication 4, caractérisé en ce qu'il présente une face (23) opposée à ladite face présentant l'ouverture (22) de laquelle sortent les conducteurs (8, 9, 10, 11) connectés au capteur (1).

6. Support de capteur conforme à la revendication 5, caractérisé en ce que les conducteurs (8, 9, 10, 11) issus du capteur (1, 26) sont noyés dans une bande souple (12) en matière isolante suffisamment mince pour pouvoir passer entre le couvercle (13) du compteur et le corps (14) de celui-ci, sans modification de ceux-ci.

## Patentansprüche

1. Träger eines optoelektronischen Sensors für einen Stromverbrauchszähler, der an der Frontfläche seines Deckels (13) eine Anzeigeplatte (15) mit einem Fenster (16) aufweist, hinter dem ein Drehorgan (2) drehbar gelagert ist, dessen Drehgeschwindigkeit von dem Verbrauch abhängt, und wobei der optoelektronische Sensor (1) dazu bestimmt ist, in einer Gegenüberlage bezüglich des Drehorgans (2) angebracht zu werden, um den Durchlauf einer von dem Drehorgan getragenen Markierung (3) bei jeder Drehung desselben zu erfassen, dadurch gekennzeichnet, daß der Träger (7) des Sensors (1) eine Fläche (17) aufweist, die mit einer elastischen Zunge (18) versehen ist, die geeignet ist, den Rand (15a) der Anzeigeplatte (15) zu überdecken, wobei die gleiche Fläche (17) des Trägers (7) einen Vorsprung (19) aufweist, der in das Ende des Fensters (16) der Anzeigeplatte eingreifen kann, das an den von der Zunge (18) des Trägers (7) bedeckten Rand (15a) desselben angrenzt.

2. Sensorträger nach Anspruch 1, dadurch gekennzeichnet, daß die Abmessungen des Vorsprungs (19) so festgelegt sind, daß der Vorsprung im wesentlichen ohne Spiel in das Ende des Fensters (16) paßt.

3. Sensorträger nach einem der Ansprüche 1 oder 2, dadurch gekennzeichnet, daß der Boden (20a) der Auskehlung (20), die zwischen der Zunge (18) und der Fläche (17) des Trägers (7) gebildet ist, in einem Abstand von dem Vorsprung (19) liegt, der im wesentlichen gleich dem Abstand zwischen dem Rand (15a) der Platte und dem Ende ihres Fensters (16) ist.

4. Sensorträger nach einem der Ansprüche 1 bis 3, dadurch gekennzeichnet, daß er eine Fläche (21) aufweist, die senkrecht zu der verläuft, die die Zunge (18) und den Vorsprung (19) trägt, wobei diese Fläche (21) eine Öffnung (22) aufweist, die mit dem Aufnahmeraum des Sensors (1) in Verbindung steht, wobei der Abstand zwischen dem Vorsprung (19) und der Fläche (21) so bestimmt ist, daß der Sensor (1) hinter der Öffnung (22) in einem konstanten und geeigneten Abstand vom Drehorgan (2) gehalten wird, das drehbar in einer Ebene parallel zu der Fläche angebracht ist.

5. Sensorträger nach Anspruch 4, dadurch gekennzeichnet, daß er eine der die Öffnung (22) aufweisenden Fläche gegenüberliegende Fläche (23) enthält, aus der die an den Sensor (1) angeschlossenen Leiter (8, 9, 10, 11) austreten.

6. Sensorträger nach Anspruch 5, dadurch gekennzeichnet, daß die von dem Sensor (1, 26) kommenden Leiter (8, 9, 10, 11) in ein biegsames Band (12) aus isolierendem Material eingebettet sind, das genügend dünn ist, damit es zwischen dem Deckel (13) des Zählers und dessen Körper (14) ohne deren Änderung hindurchgeführt werden kann.

## Claims

1. A support for an opto-electronic sensor for an electricity consumption meter, said meter comprising, on the front surface of its cover (13), a name plate (15) having a window (16) behind which there is mounted for rotation a rotary member (2), the speed of rotation on which is a function of the consumption, the opto-electronic sensor (1) being adapted to be placed in register with the rotary member (2) to detect the passage of a reference mark (3) carried by said rotary member, on each revolution of the latter, characterised in that the said support (7) for the sensor (1) comprises a surface (17) provided with a resilient tongue (28) adapted to cover the edge (15a) of the name plate (15), said surface (17) of the support (7) having a catch (19) which can be lodged at the end of the window (16) of the name plate adjacent the edge (15a) thereof covered by the tongue (18) of the support (7).

2. A sensor support according to claim 1, characterised in that the dimensions of the catch (19) are such that the catch can be fitted substantially without play in said end of the window (16).

3. A sensor support according to claim 1 or 2, characterised in that the bottom (20a) of the groove (20) defined between the tongue (18) and the said surface (17) of the support (7) is located at a distance from the catch (19) substantially equal to the distance between the edge (15a) of the plate and the end of the window (16) thereof.

4. A sensor support according to any one of claims 1 to 3, characterised in that it has a surface (21) perpendicular to the surface having the tongue (18) and the catch (19), said surface (21) having an aperture (22) communicating with the receptacle of the sensor (1), the distance between the catch (19) and the said surface (21) being such as to keep the sensor (1) lodged behind the aperture (22) at constant and suitable distance from the rotary member (2) mounted for rotation in a plane parallel to said surface.

5. A sensor support according to claim 4, characterised in that it has a surface (23) remote from the said surface having the aperture (22), from which the conductors (8, 9, 10, 11) connected to the sensor (1) emerge.

6. A sensor support according to claim 5, characterised in that the conductors (8, 9, 10, 11) emerging from the sensor (1, 26) are embedded in a flexible strip (12) of insulating material thin enough to be able to pass between the cover (13) of the meter and the body (14) thereof without any modification of the **s**ame.
